(19) **Europäisches Patentamt**
**European Patent Office**
**Office européen des brevets**

(11) **EP 1 528 083 B1**

(12) **EUROPEAN PATENT SPECIFICATION**

(45) Date of publication and mention
of the grant of the patent:
**02.12.2009 Bulletin 2009/49**

(51) Int Cl.:
**C08K 13/06** (2006.01)    **C08K 9/04** (2006.01)
**C08K 3/00** (2006.01)

(21) Application number: **04256607.5**

(22) Date of filing: **27.10.2004**

(54) **Flame retardant resin composition, process for producing the same, flame-retardant-resin formed article, and process for producing flame-retardant fine particle**

Flammhemmende Harzzusammensetzung, ihr Herstellungsverfahren, flammhemmendes Harzgegenstand, und Herstellungsverfahren von flammhemmende feine Partikeln

Composition de résine ignifuge, son procédé de production, article en résine ignifuge, et procédé de production de fines particules ignifuges

(84) Designated Contracting States:
**DE FR GB**

(30) Priority: **27.10.2003 JP 2003365725**

(43) Date of publication of application:
**04.05.2005 Bulletin 2005/18**

(73) Proprietor: **FUJI XEROX CO., LTD**
**Minato-ku**
**Tokyo 107-0052 (JP)**

(72) Inventors:
• **Okoshi, Masayuki,**
**Fuji Xerox**
**Minamiashigara-shi**
**Kanagawa (JP)**

• **Okubo, Naoto**
**Ichihara-shi**
**Chiba (JP)**
• **Okumura, Hiroshi**
**Asashi-ku**
**Osaka-shi**
**Osaka (JP)**

(74) Representative: **Hallam, Arnold Vincent et al**
**Marks & Clerk LLP**
**Alpha Tower**
**Suffolk Street Queensway**
**Birmingham**
**B1 1TT (GB)**

(56) References cited:
**WO-A-00/66657    WO-A-03/002652**
**US-A- 5 827 906**

**Description**

BACKGROUND OF THE INVENTION

Field of the Invention

The present invention relates to a flame-retardant resin composition comprising a resin and flame-retardant fine particles, a process for producing the same, a flame-retardant-resin formed article, and process for producing flame-retardant fine particles. The flame-retardant resin is used in chassis of home electric appliances and OA products, electric wires, cables, automobiles, boats and ships, aircraft, trains, building materials, electronic devices, and printed circuit boards, for protection from damage due to heat from fire or the like.

Description of the Related Art

For the purpose of flame retardation, halogen compounds, antimony trioxide, phosphorus compounds, and hydrated metal compounds have been used as flame retardants in resins (matrix resins). However, use of halogen compounds and antimony trioxide are becoming more restricted, due to increasing concern about the environmental impact of these compounds. In addition, hydrated metal compounds lead to drastic deterioration of physical properties of polymers, since they require a greater amount thereof to be blended in order to obtain the same level of flame retardancy as other organic flame-retardant compounds.

Further, some phosphorus-containing flame retardants (low-molecular weight compounds) are regulated under an EU directive (76/769/EEC) regarding the sales and use of hazardous substances having carcinogenicity, mutagenicity, reproductive toxicity (CMR), and thus there are still some doubts about the safety of these phosphorus compounds. Under the circumstances, hydrated metal compounds and condensed phosphorus compounds are mostly used currently in environment-friendly flame-retardant resins, even while taking into account the adverse effect of these flame-retardants on the physical properties of polymers.

Recently, a polymeric nanocomposite composition containing a polyamide and a modified silicate, and a polycarbonate blend containing a graft polymer, a phosphonate amine and inorganic nanoparticles were proposed as examples of a flame retardant including fine particles (e.g., Japanese Patent Application Laid-Open (JP-A) Nos. 2003-517488 and 2003-509523), but neither of these compositions could solve the problems described above when used as a flame retardant.

Accordingly, there exists a need for a new flame-retardant resin composition causing smaller decrease in the mechanical and physical properties of matrix resins and having a lower environmental burden, a process for producing the same, a flame-retardant-resin formed article employing the same, and a process for producing flame-retardant fine particles, and more specifically for a new inorganic flame retardant that provides a flame retardancy equivalent to that of other organic flame-retardant compounds and does not cause a significant decrease in the physical properties of polymers.

SUMMARY OF THE INVENTION

Hitherto, flameproofing of resins by conventional flame retardants have been studied by blending a large amount (about 50 to about 150 parts by weight) of flame retardant particles having a particle diameter in the range of 1 to 50 $\mu$m with resins. Because blending of such large amount of particles leads to deterioration of the mechanical and electrical properties of the resins, the conventional flame retardants are often blended with other additives, or other resins.

To satisfy the above need, the inventors of the invention have studied intensively on a method of preparing flame retardant fine particles having an increased specific surface, which results in increased contact area thereof with polymers. As a result, the inventors have found that blending with a polymer flame retardant fine particles having a volume average particle diameter in the range of about 1 to about 200 nm and including inorganic fine particles and, on the surfaces of the inorganic fine particles, an organic compound containing a hydrophobic group that can bind to the inorganic fine particles can give the polymer flame retardancy whose level is similar to that of a conventional flame-retardant compound having a volume average particle diameter of about 0.5 to 50 $\mu$m, even if the blending amount of the flame retardant fine particles is smaller than that of the conventional flame-retardant compound.

According to a first aspect of the invention there is provided a flame-retardant fine particle, comprising an inorganic fine particle made of a hydrated metal compound selected from aluminium hydroxide, magnesium hydroxide and calcium hydroxide and an organic compound on the surface of the inorganic fine particle and having a volume average particle diameter of between 1 to 500 nm and an aspect ratio of between 1 to 10, wherein the flame retardant fine particle is a material that is granular.

According to a second aspect of the invention there is provided a flame-retardant resin composition, comprising a matrix resin, and the flame-retardant fine particles of the first aspect blended therein.

According to a third aspect of the invention there is provided flame-retardant resin formed article, formed from a flame-retardant resin composition by one or more forming machines selected from a press molding machine, an injection molding machine, a molding machine, a blow molding machine, an extrusion molding machine, and a fiber forming machine, wherein the flame-retardant resin composition is in accordance with the second aspect.

According to a fourth aspect of the invention there is provided a process for producing flame-retardant resin compositions, comprising blending at least a matrix resin and flame-retardant fine particles by one or more kneading machines selected from a roll mill, a kneader, a Banbury mixer, an intermixer, a uniaxial extruder, and a biaxial extruder, wherein the flame-retardant fine particles are in accordance with the first aspect.

According to a fifth aspect of the invention there is provided a process for producing flame-retardant fine particles in accordance with the first aspect, comprising: preparing a suspension of an organic compound having a reactive group at a terminal of a hydrophobic group and/or in the hydrophobic group; adding an inorganic compound having a group capable of binding to the reactive group to the suspension to conduct reaction between the inorganic compound and the organic compound; and hydroxylating a product obtained by the reaction.

In the flame-retardant resin composition of the invention, a matrix resin is blended with flame-retardant fine particles having a greater specific surface and a greater contact area thereof with the matrix resin. Therefore, the difference between the mechanical and physical properties of the resin alone and those of the resin including the flame-retardant resin particles is small. In addition, the environment burden of the flame-retardant resin composition is also small. The invention can also provide a process for producing the same, a flame-rctardant-resin formed article made of the same, and a process for producing flame-retardant fine particles.

BRIEF DESCRIPTION OF THE DRAWINGS

Preferred embodiments of the invention will be described in detail based on the following figures, wherein:

Fig. 1 is a graph showing the relationship between the burning time and the heat release rate of the respective formed resin articles obtained in Examples and Comparative Examples;
Fig. 2 is a graph showing the peak of heat release rates of the respective formed resin articles obtained in Examples and Comparative Examples;
Fig. 3 is a graph showing the reduction rates of peak of heat release rates of the formed resin articles obtained in Examples and Comparative Examples relative to that of EVA alone; and
Fig. 4 is a graph showing the smoke emission generated from the respective formed resin articles obtained in Examples and Comparative Examples.

DETAILED DESCRIPTION OF THE INVENTION

Hereinafter, the invention will be described in detail. <Flame-retardant resin composition and process for producing the same>

The flame-retardant resin composition of the invention includes a matrix resin and a specific flame-retardant fine particles blended therein.

As described above, in order to obtain the same level of flame retardancy, the amount of flame-retardant particles, which are conventionally used, blended with a matrix resin should be larger than that of organic flame-retardant compound such as a hydrated metal compound, thus leading to drastic deterioration in physical properties of the matrix polymer. Therefore, for prevention of the deterioration in the physical properties of polymers, the amount of the flame retardant blended should be reduced.

A promising method for reducing the amount of a flame retardant blended is to prepare finer flame-retardant particles. The finer flame-retardant particles have an increased specific surface and consequently an increased contact area with a polymer, which is expected to increase the flameproofing effect of the flame retardant.

However, it was found that the finer flame-retardant particles tend to flocculate when simply added to a matrix resin and that it is difficult to uniformly disperse the finer particles in the resin.

The inventors have found that a flame-retardant resin composition which includes particular flame-retardant fine particles (flame retardant) having an improved dispersibility in a matrix resin (base resin), has sufficient flame retardancy and does not deteriorate the physical properties of the base polymer can solve the above problem.

In the invention, the term "flame retardant" means that, when 5 parts by weight of a flame-retardant compound is blended with an ethylene-vinyl acetate copolymer resin, the peak of heat release rate, as specified by ISO 5660-1, of the resultant mixture is lower than that of the copolymer resin alone by 25% or more.

The flame-retardant resin composition of the invention includes a matrix resin and granular flame-retardant fine particles having a volume average particle diameter in the range of about 1 to about 500 nm and dispersed in the matrix resin.

The flame-retardant fine particles in the invention are granular in shape. The shape of the particles is not particularly limited as long as the particles retain the flame retardancy described above. The shape may be spherical or nonspherical (including elliptical, polygonal, spindle-shaped, spicular, and columnar) but is not flake-shaped. The aspect ratio of the particles is preferably in the range of about 1 to about 50, and more preferably in the range of about 1 to about 10. In addition, the flame-retardant fine particles may be used in the form of sol.

Granular flame-retardant fine particles are preferable, since they are more easily dispersed in a matrix resin than flake-shaped particles. The amount of the granular flame-retardant fine particles necessary to obtain desired flame retardancy is smaller than that of flake-shaped particles.

The volume average particle diameter of the flame-retardant fine particles (the average of the diameters of the circumscribed circles of the flame-retardant fine particles if the particles are nonspherical) is in the range of about 1 to about 500 nm. The volume average particle diameter is preferably in the range of about 1 to about 200 nm, more preferably in the range of about 5 to about 200 nm, and still more preferably in the range of about 10 to about 200 nm (particularly about 10 to about 100 nm).

The volume average particle diameter of the flame-retardant fine particles of less than 1 nm leads to deterioration in flame-retardancy retention capacity, while the volume average particle diameter of over 500 nm leads to flame retardancy similar to those of commercially available flame-retardant particles having a volume average particle diameter of 1 $\mu$m and requires a large amount of the particles to be blended in order to obtain sufficient flame retardancy. Flame-retardant fine particles having a volume average particle diameter in the above range can be uniformly dispersed in a resin. Moreover, flame-retardant fine particle having a volume average particle diameter in a nanometer size can also form minute complexes and can provide foamed resinous bodies having high transparency.

The volume average particle diameter may be measured by a laser Doppler method.

The flame-retardant fine particles used in the invention are preferably made of inorganic fine particles and an organic compound on the surfaces of the inorganic fine particles.

The inorganic fine particles are not particularly limited as long as they retain a flame-retardant component. Examples thereof include hydrated metal compounds such as aluminum hydroxide, magnesium hydroxide and calcium hydroxide; and hydrates such as calcium aluminate, calcium sulfate dihydrate, zinc borate and barium metaborate. Among them, magnesium hydroxide, aluminum hydroxide and calcium hydroxide are preferable.

The organic compound is preferably present on the surfaces of the inorganic fine particles as an organic layer. When the organic layer is formed on the surfaces of the inorganic fine particles, the flame-retardant component is more stabilized in the inorganic fine particles, and affinity between the flame-retardant fine particles and the matrix resin can be drastically improved.

The organic compound preferably has at least one hydrophobic group that can bind to the inorganic fine particles. A thin organic layer can be uniformly formed on the surfaces of the inorganic fine particles by binding the hydrophobic group to the inorganic fine particles.

The organic compound preferably has at the terminal of the hydrophobic group a binding group for forming a bond with the inorganic fine particles.

Examples of the binding group include a hydroxyl group, a phosphate group, a phosphonium salt group, an amino group, a sulfate group, a sulfonate group, a carboxyl group, hydrophilic heterocyclic groups, polysaccharide groups (e.g., sorbitol, sorbit, sorbitan, sucrose esters, and sorbitan ester residues), polyether groups (e.g., polyoxyalkylene groups having an alkylene group of 2 to 4 carbon atoms, such as polyoxyethylene and polyoxypropylene groups), hydrolyzable groups (e.g., alkoxy groups having 1 to 4 carbon atoms such as methoxy, ethoxy, propoxy, isopropoxy, and butoxy groups); and halogen atoms (e.g., bromine, and chlorine).

If the binding group is an anionic group (e.g., a sulfate group, a sulfonate group, or a carboxyl group), the binding group may form a salt with any base. Examples of the base include inorganic bases (e.g., alkaline earth metals such as calcium and magnesium and alkali metals such as sodium and potassium; and ammonia); and organic bases (e.g., amines). Further, if the binding group is a cationic group (e.g., an amino group), the binding group may form a salt with any acid, including inorganic acids (e.g., hydrochloric acid, and sulfuric acid) and organic acids (e.g., acetic acid). The cationic group may form a salt with an anionic group (in particular, a carboxyl or sulfate group). Alternatively, the organic compound may have both a cationic group and an anionic group as the binding groups.

As described above, preferred examples of the binding group include ionic groups (anionic and cationic groups) and hydrolyzable groups, and thus the bond between the binding group and the inorganic fine particles may be either an ionic or covalent bond.

Examples of the hydrophobic group of the organic compound include groups functioning as a hydrophobic group in surfactants (e.g., higher fatty acid residues, higher alcohol residues, and alkylaryl groups). Examples of the higher fatty acids include saturated fatty acids having about 8 to about 30 carbon atoms (preferably saturated fatty acids having about 10 to about 28 carbon atoms, and more preferably saturated fatty acids having about 12 to about 26 carbon atoms) such as lauric acid, myristic acid, palmitic acid, arachic acid, behenic acid, rignoceric acid, cerotic acid, caprylic acid, capric acid, daturic acid, stearic acid, montanic acid, and melissic acid; and unsaturated fatty acids having about 12 to about 30 carbon atoms (preferably unsaturated fatty acids having about 14 to about 28 carbon atoms, and more preferably unsaturated fatty acid having about 14 to about 26 carbon atoms) such as elaidic acid, linoleic acid, linolenic acid, linderic acid, sperum oil, oleic acid, gadoleic acid, erucic acid, and brassidic acid.

The hydrophobic group can be a higher fatty acid residue or a higher alcohol residue corresponding to the higher fatty acid (e.g., higher fatty acid residues having about 8 to about 24 carbon atoms (preferably higher fatty acid residues having about 10 to about 22 carbon atoms, and more preferably higher fatty acid residues having about 12 to about 20 carbon atoms) such as octyl, nonyl, dodecyl, tetradecyl, hexadecyl (cetyl), and octadecyl groups).

Examples of the alkylaryl group include alkyl (having about 1 to about 20 carbon atoms)- aryl (having about 6 to about 18 carbon atoms) groups, such as hexylphenyl, octylphenyl, nonylphenyl, decylphenyl, dodecylphenyl, isopropylphenyl, butylphenyl, amylphenyl, and tetradecylphenyl groups. Alkyl (having about 6 to about 18 carbon atoms)- aryl (having about 6 to about 12 carbon atoms) groups are preferable, and alkyl (having about 6 to about 16 carbon atoms)-phenyl groups are more preferable.

The hydrophobic group may further have any other substituent group (e.g., alkyl groups having about 1 to about 4 carbon atoms).

The amount of the organic compound having the binding and hydrophobic groups used is in the range of about 0.01 to about 100 parts by weight, preferably in the range of about 0. 1 to about 50 parts by weight, and more preferably in the range of about 0.5 to about 30 parts by weight (e.g., about 1 to about 30 parts by weight) with respect to 100 parts by weight of the inorganic fine particles.

If a surfactant having a polymerizable group or an organic metal compound having a polymerizable group and a hydrolyzable group (hereinafter, referred to as an organic compound having a polymerizable group) is used, the organic layer may be formed by polymerizing the polymerizable monomer. Examples of the polymerizable group include polymerizable unsaturated groups (e.g., ethylenic unsaturated groups such as vinyl, isopropenyl, and (meth)acryloyl groups).

The bond between the organic compound and the inorganic fine particles in the invention may be formed either in the presence or absence of an organic solvent. The organic solvent is not particularly limited, and examples thereof include methanol, ethyl formamide, nitromethane, ethanol, acrylic acid, acetonitrile, aniline, cyclohexanol, n-butanol, methylamine, n-amyl alcohol, acetone, methyl ethyl ketone, chloroform, benzene, ethyl acetate, toluene, diethyl ketone, carbon tetrachloride, benzonitrile, cyclohexane, isobutyl chloride, diethylamine, methylcyclohexane, isoamyl acetate, n-octane, n-heptane, isobutyl acetate, isopropyl acetate, methyl isopropyl ketone, butyl acetate, methyl propyl ketone, ethylbenzene, xylene, tetrahydrofuran, trichloroethylene, methylene chloride, pyridine, n-hexanol, isopropyl alcohol, dimethylformamide, nitromethane, ethylene glycol, glycerol formamide, and dimethylsulfoxide.

These solvents may be used alone or in combination.

The temperature of the reaction between the organic compound and the inorganic fine particles in the invention is in the range of about 0 to about 200°C, preferably in the range of room temperature to about 150°C, and particularly preferably in the range of about 10 to about 100°C.

In the invention, not only the flame-retardant fine particles described above but also a flame-retardant compound having a larger particle diameter may be used together. Combined use of these particles is effective in well dispersing these flame-retardant substances in the matrix resin, since smaller flame-retardant fine particles fill gaps between larger particles in the polymer matrix in a manner similar to that in which smaller rocks fill gaps between larger rocks in stone walls. The flame retardancy of the resulting formed article may be further improved by this advantageous effect.

The flame-retardant compound preferably has a volume average particle diameter in the range of about 0.5 to about 50 μm, and more preferably in the range of about 0.5 to about 30 μm. When the volume average particle diameter is less than 0.5 μm, the particles may be too small to form the structure similar to the stone walls. A volume average particle diameter of larger than 50 μm may lead to deterioration of the mechanical properties of a matrix polymer.

The flame-retardant compound is not particularly limited, and preferably at least one compound selected from hydrated metal compounds, inorganic hydrates, nitrogen-containing compounds, and silicon-containing inorganic fillers.

The hydrated metal compound is preferably selected from aluminum hydroxide, magnesium hydroxide, and calcium hydroxide. The inorganic hydrate is preferably selected from calcium aluminate, calcium sulfate dihydrate, zinc borate, barium metaborate, borax, kaolin, and clay. The nitrogen-containing compound is preferably sodium nitrate. The silicon-containing inorganic filler is preferably selected from molybdenum compounds, zirconium compounds, antimony compounds, dawsonite, phlogopite, and smectite.

These flame-retardant compounds may be used alone or in combination. In addition, the flame-retardant compound may be the same as or different from the compound of the inorganic fine particles to be used as the flame-retardant fine particles.

The content of the flame-retardant compound is preferably in the range of about 0.1 to about 200 parts by weight, and more preferably in the range of about 0.1 to about 50 parts by weight with respect to 100 parts by weight of the flame-retardant fine particles. When the content is less than 0.1 parts by weight, it may be too low to form a structure like the stone wall described above. A content of more than 200 parts by weight may lead to deterioration of the mechanical properties of a matrix polymer, since the amount of the flame-retardant compound is too large.

In the invention, combined use of the flame-retardant fine particles with one of smectites modified with an organic compound allows dense and uniform dispersion of the flame-retardant substances in the matrix resin, due to the advantageous effect of the flame-retardant fine particles filling gaps, in the matrix resin, among the smectite particles which have a large aspect ratio.

In addition, when the smectite particles modified by the organic compound are dispersed in a matrix resin, the resultant mixture becomes transparent. Moreover, the diameter of each of the flame-retardant fine particles in the invention is smaller than or equal to the wavelength of visible light and the flame-retardant fine particles are uniformly dispersible in the resin. Therefore, the resin containing both the smectite and the flame-retardant particles is superior in transparency.

The matrix resin of the flame-retardant resin composition in the invention is not particularly limited, as long as the resin is a polymeric compound such as a rubber or a plastic. Specific examples thereof include biodegradable resins, ABS resins, ACS resins, alkyd resins, amino resins, ASA resins, bismaleimide triazine resins, chlorinated polyether, chlorinated polyethylene, allyl resins, epoxy resins, ethylenepropylene copolymers, ethylene-vinyl acetate-vinyl chloride terpolymers, ethylene-vinyl chloride copolymers, ethylene-vinyl acetate copolymer resins, fiber reinforced plastics, ionomers, methacrylic acid ester-styrene copolymers, nitrile resins, polyester, olefin-vinyl alcohol copolymers, petroleum resins, phenol resins, polyacetal, polyacrylate, polyallylsulfone, polybenzoimidazole, polybutadiene, polybutylene, polybutylene terephthalate, polycarbonate, polyether ether ketone, polyether ketone, polyether nitrile, polyether sulfone, polyethylene, polyethylene terephthalate, polyketone, methacrylic resins, polymethylpentene, polypropylene, polyphenylene ether, polyphenylene sulfide, polysulfone, polystyrene, SAN resins, butadiene-styrene resins, polyurethane, polyvinyl acetal, polyvinylalcohol, polyvinyl chloride, polyvinylidene chloride, fluorinated resins, silicone resins, polyvinyl acetate, xylene resins, thermoplastic elastomers, EPDM, CR, BR, nitrile rubbers, natural rubbers, acrylonitrile-butadiene rubbers, fluorinated rubbers, and butyl rubbers.

Among them, biodegradable resins are particularly preferable. These resins may be used alone or in combination.

The flame-retardant resin composition in the invention may also include an additive such as a commonly used stabilizer. The additive is not particularly limited. Examples thereof include: a cross-linking agent, a cross-linking accelerator, a cross-linking acceleration aid, an activator, a cross-linking inhibitor, an aging inhibitor, an antioxidant, an antiozonant, a UV absorbent, a photostabilizer, a tackifier, a plasticizer, a softener, a reinforcer, a reinforcing agent, a forming agent, a forming aid, a stabilizer, a lubricant, a releasing agent, an antistatic agent, a modifying agent, a coloring agent, a coupling agent, an antiseptic substance, a fungicide, a modifier, an adhesive, a reodorant, a polymerization catalyst, a polymerization initiator, a polymerization inhibitor, a polymerization retarder, a polymerization modifier, a crystal nucleating agent, a compatibilizer, a dispersant, and an antifoaming agent.

These additives may be used alone or in combination.

The flame-retardant resin composition of the invention can be obtained by blending flame-retardant fine particles, a matrix resin, and optionally a flame-retardant compound, a stabilizer, and the like, and kneading the resultant mixture with a kneader.

The kneader is not particularly limited. A method of dispersing flame-retardant fine particles in a matrix resin by a shearing stress and repeated position alternation caused by a three-roll or two-roll mill, or a method of dispersing flame-retardant fine particles in a matrix resin by collisional and shearing forces caused by the sidewall of a dispersing machine, such as a kneader, a Banbury mixer, an intermixer, a uniaxial extruder, or a biaxial extruder is preferable in order to obtain high dispersibility.

The kneading temperature depends on the matrix resin used, the amount of the flame-retardant fine particles added, and the like, but is preferably in the range of about 50 to about 450°C, and more preferably in the range of about 60 to about 380°C.

On the other hand, since the flame-retardant fine particles in the invention preferably have an organic layer on the surface thereof, uniform dispersion of the particles in the resin can be attained not only by mechanical mixing by a kneader, a biaxial extruder, a roll mill, or the like, but also in a solution which dissolves or swells the matrix resin.

Further, the flame-retardant fine particles may be blended with a monomer or monomers and a polymerization solvent during production of the resin in a polymerization process. Thus, the degree of freedom in dispersing the particles in a resin is high. Moreover, as described above, the flame-retardant fine particles can exhibit high flame retardancy even at a small addition amount, whereby the mechanical strength of a composition including the flame-retardant fine particles and a matrix resin is similar to that of the matrix resin alone. These are expected to result in improved processability of the composition. Accordingly, the flame-retardant resin composition may be applied to processing methods for producing of products having various shapes such as pellets, fibers, films, sheets, and structures.

The organic solvent is not particularly limited. Examples thereof include methanol, ethyl formamide, nitromethane, ethanol, acrylic acid, acetonitrile, aniline, cyclohexanol, n-butanol, methylamine, n-amyl alcohol, acetone, methyl ethyl ketone, chloroform, benzene, ethyl acetate, toluene, diethyl ketone, carbon tetrachloride, benzonitrile, cyclohexane, isobutyl chloride, diethylamine, methylcyclohexane, isoamyl acetate, n-octane, n-heptane, isobutyl acetate, isopropyl acetate, methyl isopropyl ketone, butyl acetate, methyl propyl ketone, ethylbenzene, xylene, tetrahydrofuran, trichloroethylene, methyl ethyl ketone, methylene chloride, pyridine, n-hexanol, isopropyl alcohol, dimethylformamide, nitromethane, ethylene glycol, glycerol formamide, dimethylformamide, and dimethylsulfoxide.

These organic solvents may be use alone or in combination.

The blending temperature is in the range of about 0 to about 200°C, preferably in the range of room temperature to about 150°C, and particularly preferably in the range of about 10 to about 100°C. The reaction may be conducted under pressure or under normal pressure.

In the flame-retardant resin composition after kneading or dispersion in a solution, it is preferable that the flame-retardant fine particles are uniformly dispersed in the form of particles having a primary particle diameter. The dispersion state may be easily checked by measuring the transmittance of a sheet of the flame-retardant resin composition with respect to ultraviolet and/or visible light.

In a typical measurement method, 0.5 g of flame-retardant fine particles are dispersed in a solution in which 10 g of an ethylene-vinyl acetate copolymer (trade name: EV260, manufactured by Du Pont-Mitsui Polychemicals Co., Ltd.) is dissolved in 100 mL of tetrahydrofuran; the sample solution thus obtained is placed on a glass substrate and dried at 60°C for 3 hours to form a film having a thickness of 20 $\mu$m; and the transmittance of the film is measured by an ultraviolet-visible light spectrophotometer.

The transmittance obtained by the above measurement method is preferably in the range of about 40 to about 90%, more preferably in the range of about 60 to about 90% at a wavelength of 550 nm.

Second flame-retardant resin composition

The flame-retardant particle of the flame-retardant resin composition of the invention have a diameter smaller than that of conventional flame-retardant particles, and therefore have an increased specific surface. As a result, the flame retardant particles have an increased contact area with a polymer (matrix resin), improving flame retardancy.

In addition, the flame-retardant fine particles of the invention have an organic layer (organic compound) on the surfaces thereof, and therefore can be uniformly dispersed in the resin, and exhibit improved flame-retarding effect.

In particular, the peak of heat release rate, as specified in ISO 5660-1, of the flame-retardant resin composition of the invention including a matrix resin and flame-retardant fine particles is preferably smaller than that of the matrix resin without the flame-retardant fine particles by 30 % or more.

Further, as described above, the flame-retardant fine particles in the invention have a smaller diameter and therefore have an increased specific surface, an increased contact area with the polymer, and improved flame retardancy. Moreover, the flame-retardant fine particles suppress generation of soot (carbide) during combustion, which is a low smoke emission function.

In addition, the flame-retardant fine particles in the invention provide improved flame retardancy even if the addition amount thereof is small. Therefore, the resin composition of the invention has properties similar to those of a matrix resin including no flame-retardant fine particle and good mechanical properties. Further, the flame-retardant fine particles in the invention have a size smaller than the wavelength of visible light and are uniformly dispersed in a matrix resin. Therefore, when the flame-retardant fine particles in the invention alone are used in the resin, the resulting flame-retardant resin composition is higher in transparency,

<Flame-retardant-resin formed article>

A flame-retardant-resin formed article of the invention is formed out of the flame-retardant resin composition of the invention with a forming machine.

One or more machines selected from a press molding machine, an injection molding machine, a molding machine, a blow molding machine, an extrusion molding machine, and a fiber forming machine may be used as the forming machine. Accordingly, the formed article may be formed by one of the above machines or continuously by a forming machine and then another forming machine.

The shape of the flame-retardant-resin formed article of the invention thus produced is not particularly limited and may be a sheet, a rod, or fiber. The size thereof is not limited, too.

The flame-retardant-resin formed article of the invention may be used, for example, as packaging or a building material in the form of a sheet, or as the part of an Office Automation (OA) instrument such as the outer case of a copying machine or a printer, or an internal part in the form of a structural article.

<Process for producing flame-retardant fine particles>

Hereinafter, a process for producing flame-retardant fine particles according to the invention will be described.

The process for producing flame-retardant fine particles according to the invention includes: preparing a suspension of an organic compound having a reactive group at a terminal of a hydrophobic group and/or in the hydrophobic group; adding an inorganic compound having a group capable of binding to the reactive group to the suspension to conduct reaction between the inorganic compound and the organic compound; and hydroxylating a product obtained by the reaction.

As described above, the flame-retardant resin composition of the invention contains uniform flame-retardant fine particles having a diameter of a nanometer size and a degree of dispersion in a particular range. Conducting the process for producing flame-retardant fine particles of the invention makes it possible to efficiently, reliably, and inexpensively produce flame-retardant fine particles having a diameter and a degree of dispersion in the ranges described above.

Hereinafter, each step of the process for producing flame-retardant fine particles according to the invention will be described. Preparation of suspension

An organic compound used in this step has a reactive group at least at a terminal of a hydrophobic group and/or in the hydrophobic group.

Examples of the hydrophobic group include the various hydrophobic groups and the preferred hydrophobic groups exemplified in the explanations for the flame-retardant resin compositions of the invention.

The reactive group is not particularly limited, and examples thereof include the binding groups and the preferable binding groups for forming bonds with the inorganic fine particles exemplified in the explanations for the flame-retardant resin compositions of the invention. Plural reactive groups may be present at the terminal of the hydrophobic group and/or in the hydrophobic group. However, it is preferable that only one reactive group is present. In this case, the one reactive group is preferably present at the terminal of the hydrophobic group.

The organic compound is dispersed in a solvent which does not dissolve the organic compound to prepare the suspension of the organic compound. However, an organic compound having both a hydrophobic group and a reactive group, such as the organic compound used in the invention, usually forms micelles in liquid (dispersion medium) to form a suspension.

When water is used as the dispersion medium in this case, micelles having the hydrophobic groups inside (at the centers of micelles) and the reactive groups outside (at the interfaces with the dispersion medium) are formed. Alternatively, when an oil-based solvent is used as the dispersion medium, micelles having the hydrophobic groups outside and the reactive groups inside are formed.

In addition to water, various organic solvents may be used as the dispersion medium in the invention. However, micelles having the reactive groups outside and the hydrophobic groups inside are preferable from the viewpoint of reaction efficiency between the reactive group of the hydrophobic group and an inorganic compound in liquid. Accordingly, water is preferably used as the dispersion medium.

The content of the organic compound in the suspension is preferably in the range of about 0.1 to about 100 parts and more preferably in the range of about 1 to about 10 parts by weight with respect to 100 parts of the dispersion medium. This is because some organic compounds have a so-called critical micelle concentration (CMC) outside the range of about 0.01 to about 0.1 parts by weight and thus cannot form micelles.

The volume average particle diameter of the micelles (suspended particles) is preferably in the range of about 1 to about 1000 nm and more preferably in the range of about 1 to about 200 nm. When the volume average particle diameter is larger than 1000 nm, micelles may coalesce. When it is less than 1 nm, the micelles may become too smaller at the time that the inside and outside phases of micelles are reversed in the next step. When the particles (micelles) are blended with a resin, such micelles cannot sufficiently impart flame retardancy to the resulting flame-retardant composition.

Conducting reaction between organic compound and inorganic compound

In this step, an inorganic compound having a group that can bind to the reactive group is added to the suspension prepared above, and the inorganic compound is allowed to react with the organic compound.

The inorganic compound is not particularly limited as long as it has a group that can form a bond with the reactive group of the organic compound (hereinafter, referred to as a "group capable of binding"). However, an inorganic compound which ionically binds to an ionic group (anionic or cationic group) serving as the reactive group of the organic compound to form a salt is preferable in this step.

Accordingly, when the organic compound has an anionic group (e.g., a sulfate group, a sulfonate group, or a carboxylate group), the group capable of binding in the inorganic compound is preferably a base, and typical examples thereof include those described above. Alternatively, when the organic compound has a cationic group (e.g., an amino group), the group capable of bonding in the inorganic compound is preferably an acid, and typical examples thereof include those exemplified above.

In particular in the invention, the inorganic compound preferably has an inorganic base (e.g., an alkaline earth metal such as calcium or magnesium, an alkali metal such as sodium or potassium, or ammonia) as the group capable of binding, and such a compound containing the inorganic base is preferably an inorganic halide compound. Among them, inorganic chloride compounds are more preferable, and metal chlorides are particularly preferably. Typical examples of the metal chlorides include magnesium chloride, aluminum chloride, calcium chloride, and iron chloride. Among them, magnesium chloride is preferable.

The reaction between the organic compound and the inorganic compound is performed by mixing a solution of the inorganic compound with the suspension of the organic compound prepared in the former step. The amount of the inorganic compound added is preferably in the range of about 1 to about 500 parts by weight and more preferably in the range of about 10 to about 200 parts by weight with respect to 100 parts by weight of the organic compound in the suspension.

The concentration of the inorganic compound in the solution is preferably in the range of about 0.1 to about 80% by weight. The solvent of the inorganic compound solution is preferably water.

The reaction temperature is preferably in the range of about 0 to about 200°C, more preferably in the range from room temperature to about 150°C, and still more preferably in the range of about 10 to about 100°C.

As described above, the organic compound becomes micellar particles, preferably having the reactive groups outside the micelles (dispersion medium side), in the step of forming the suspension of the organic compound which step is in the process for producing flame-retardant fine particles of the invention. Flame-retardant fine particle precursor having an inorganic compound at the external surfaces of the micelles can be formed by adding the inorganic compound to the suspension and then allowing the inorganic compound to form bonds with the reactive groups.

The flame-retardant fine particle precursor in the invention include flame-retardant fine particle precursor having an inorganic compound outside the micelles. However, as described above, the micelles preferably have the hydrophobic groups outside the micelles in order to enable dispersion of the fine particles having a size of nanometer into a matrix resin. For that reason, the flame-retardant fine particle precursor having the inorganic compound at the external surfaces of the micelles thus prepared are preferably converted to reversed micelles (micelles having the hydrophobic groups outside).

The conversion to the reversed micelles (reverse micellization) can be easily performed, for example, by developing sol of flame-retardant fine particle precursor having an inorganic compound at the external surfaces of micelles in an organic solvent. Examples of the organic solvent include methanol, ethyl formamide, nitromethane, ethanol, acrylic acid, acetonitrile, aniline, cyclohexanol, n-butanol, methylamine, n-amyl alcohol, acetone, methyl ethyl ketone, chloroform, benzene, ethyl acetate, toluene, diethyl ketone, carbon tetrachloride, benzonitrile, cyclohexane, isobutyl chloride, diethylamine, methylcyclohexane, isoamyl acetate, n-octane, n-heptane, isobutyl acetate, isopropyl acetate, methyl isopropyl ketone, butyl acetate, methyl propyl ketone, ethylbenzene, xylene, tetrahydrofuran, trichloroethylene, methylene chloride, pyridine, n-hexanol, isopropyl alcohol, dimethylformamide nitromethane, ethylene glycol, glycerol formamide, and dimethylsulfoxide.

In the invention, flame-retardant fine particles are prepared by hydroxylating the flame-retardant fine particle precursor thus prepared in the organic solvent and thus converting the inorganic compound bound to the organic compound into hydroxide (hydroxylation step).

In the hydroxylation step, an alkaline solution, for example, conc. ammonia, or an aqueous potassium hydroxide solution, may be used in the hydroxylation. About 0.1 to about 10 equivalences of the alkaline solution is required for hydroxylation of one equivalence of hydroxyl group, and the concentration of the alkaline solution is preferably about 0.1 to about 80 % by weight. The various solvents exemplified above may be used as the solvent.

The hydroxylation may be carried out in water or in an organic solvent compatible with the hydrophobic group of the organic compound.

When the reverse micellization is conducted, the hydroxylation may be conducted before or after the reverse micellization. For example, when the flame-retardant fine particle precursor having the inorganic compound at the external surfaces of micelles are hydroxylated in the organic solvent compatible with the hydrophobic group, the hydroxylation and the reverse micellization may be carried out at the same time.

Desired flame-retardant fine particles are obtained by separating the flame-retardant fine particles by centrifugation of sol thereof, or decantation of the solution into a poor solvent, and drying the resulting fine particles.

The process for producing flame-retardant fine particles of the invention makes it possible to produce flame-retardant fine particles having a volume average particle diameter (average of the diameters of circumscribing circles of the particles, when the flame-retardant fine particles are not spherical) in the range of about 1 to about 500 nm.

The diameter of the flame-retardant fine particles is preferably in the range of about 1 to about 200 nm, more preferably in the range of about 5 to about 200 nm, and still more preferably in the range of about 10 to about 200 nm (particularly, about 10 to about 100 nm).

When the volume average particle diameter of the flame-retardant fine particles is less than 1 nm, the fine particles tend to more rapidly lose flame-retardancy. When it is larger than 500nm, the fine particles have properties similar to those of commercially available particles having a volume average particle diameter of 1 $\mu$m. Accordingly,

adding an increased amount of such particles is needed to provide desired flame retardancy. In addition, the flame-retardant fine particles having a volume average particle diameter in the above range can be more uniformly dispersed in a resin. Further, the flame-retardant fine particles having a volume average particle diameter of nanometer size allow formation of finer complexes and thus provide flame-retardant resin compositions having higher transparency.

The degree of dispersion of the flame-retardant fine particles is preferably in the range of about 0.1 to about 3.0. The degree of dispersion is more preferably in the range of about 0.1 to about 1.0 and still more preferably in the range of about 0.1 to about 0.8.

A smaller degree of dispersion indicates a narrower particle size distribution of the flame-retardant particles, i.e., more uniform particle size. Accordingly, use of fine particles having a degree of dispersion in the above range leads to uniformity in flame-retardancy and physical properties when the fine particles are dispersed in a resin.

The volume average particle diameter and the degree of dispersion are measured with a laser Doppler heterodyne particle size distribution analyzer (MICROTRAC-UPA150 manufactured by UPA Nikkiso Co., Ltd.). Specifically, the volume average particle diameter is obtained by drawing a cumulative distribution curve starting at the smallest particle diameter according to volume on the basis of the measured particle size distribution data, and determining the particle diameter corresponding to a cumulated value of 50%. When another particle size distribution curve starting at the smallest particle diameter is drawn according to weight and the particle diameter corresponding to a cumulated value of 90 % is $D_{90}$ and that corresponding to a cumulated value of 10 % is $D_{10}$, the degree of dispersion is defined by the following Formula (1):

$$\text{Degree of dispersion} = \log (D_{90}/D_{10}) \text{ --- Formula (1)}$$

EXAMPLES

Hereinafter, the invention will be described in detail with reference to Examples. However, it should be understood that the invention is not limited to the following Examples.

Preparation of flame-retardant fine particle A

10 mL of an aqueous solution containing 2.03 g of magnesium chloride hexahydrate is dripped into 100 mL of a suspension in which 5.76 g of sodium n-dodecylsulfate (NS Soap SS-40N manufactured by Kao Corporation, and having purity of 99.8 %) is dissolved in water at room temperature and the resultant mixture is dried. The resultant residue is dissolved in toluene. After removal of undissolved matters from the resultant solution by filtration, 10 mL of 1 N aqueous potassium hydroxide solution is added to the solution to obtain magnesium hydroxide sol. The sol is reprecipitated by centrifugation. The resultant precipitate is dried with a vacuum dryer to obtain 1.78 g of magnesium hydroxide sol (flame-retardant fine particle A sol).

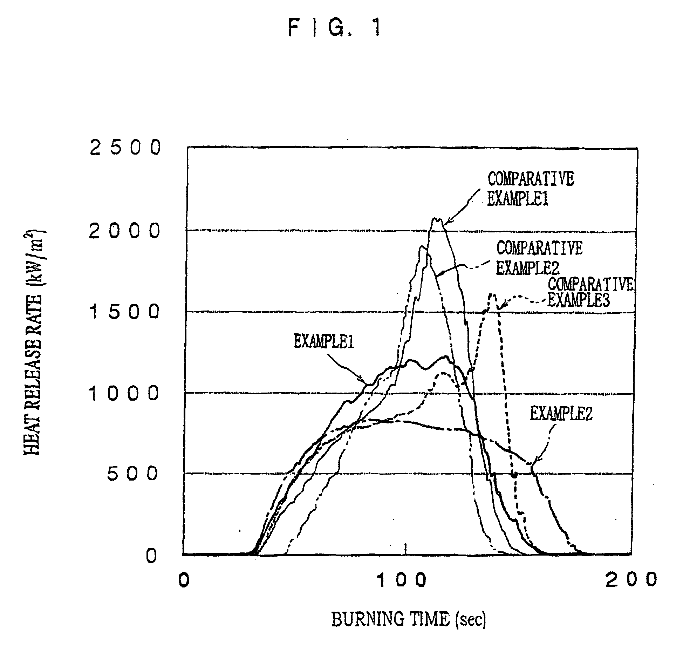

The sol thus obtained is dispersed in toluene, and the particle size distribution of the sol is measured with a heterodyne particle size distribution analyzer (MICROTRAC-UPA 150 manufactured by Nikkiso Co., Ltd.). The particles have a. volume average particle diameter of 10.9 nm. As shown in Figure 1, which is obtained by photographing the particles with a transmission electron microscope (FEI Company Tecnai G2), the flame-retardant fine particles A have a spherical shape and an aspect ratio of about 1.0. Thermal analysis of the particles shows that moisture content thereof is 22 % by weight.

Preparation of flame-retardant fine particle B

100 mL of an aqueous $10 \times 10^{-3}$ mol/L of sodium hydroxide solution (37854-08™ manufactured by Kanto Kagaku) is dripped into 100 mL of a suspension containing $1.0 \times 10^{-3}$ mol/L of isostearic acid (I0281™ manufactured by Tokyo Kasei Kogyo), and the resultant mixture is stirred with a magnetic stirrer at 60°C for 3 hours. 100 mL of an aqueous solution containing $3.3 \times 10^{-3}$ mol/L of magnesium chloride hexahydrate (25009-00™ manufactured by Kanto Kagaku, and having a special grade according to Japanese Industrial Standard) is dripped into the stirred solution, and the resultant mixture is stirred with a magnetic stirrer at 60°C for 3 hours. Then, 5 g of sodium chloride is added to the mixture to cause salting out.

A precipitate obtained by the salting out is dissolved in 100 mL of tetrahydrofuran at room temperature, and the resultant solution is filtered through a filter paper having a pore size of 5 μm under a reduced pressure. One mL of conc. ammonia (01266-00™ manufactured by Kanto Kagaku, and having a special grade according to Japanese Industrial Standard) is added to the resultant filtrate and the resulting mixture is stirred at 50°C for 3 hours. The mixture is evaporated with an evaporator. The residue is dissolved in 100 mL of toluene (40500-01™ manufactured by Kanto Kagaku), and the resultant solution is filtered through a filter paper having a pore size of 3 $\mu$m under a reduced pressure. Magnesium sulfate (25035-00™ manufactured by Kanto Kagaku, and having a cica-special grade) is added to the resultant filtrate and the resultant is left around the clock. After the aqueous phase of the resultant is separated with a separatory funnel, the organic phase is evaporated with an evaporator to obtain flame-retardant fine particles B. Preparation of flame-retardant fine particle C

100 mL of an aqueous solution containing $3.3 \times 10^{-3}$ mol/L of magnesium chloride hexahydrate (25009-00™ manufactured by Kanto Kagaku, and having a special grade according to Japanese Industrial Standard) is dripped into 100 mL of a suspension containing $0.25 \times 10^{-3}$ mol/L of sodium dodecylsulfate, and the resultant mixture is stirred with a magnetic stirrer at 60°C for 3 hours. Then, 5 g of sodium chloride is added to the mixture to cause salting out.

A precipitate obtained by the salting out is dissolved in 100 mL of tetrahydrofuran at room temperature, and the resultant solution is filtered through a filter paper having a pore size of 5 $\mu$m under a reduced pressure. One mL of conc. ammonia (01266-00™ manufactured by Kanto Kagaku, and having a special grade according to Japanese Industrial Standard) is added to the filtrate, and the resultant mixture is stirred at 50°C for 3 hours. The mixture is evaporated with an evaporator. The residue is dissolved in 100 mL of toluene (40500-01™ manufactured by Kanto Kagaku), and the resultant solution is filtered through a filter paper having a pore size of 3 $\mu$m under a reduced pressure. Magnesium sulfate (25035-00™ manufactured by Kanto Kagaku, and having a cica-special grade) is added to the filtrate and the resultant is left around the clock. After the aqueous phase of the resultant is separated with a separatory funnel, the organic phase is evaporated with an evaporator to obtain flame-retardant fine particles C. Preparation of flame-retardant fine particle D

100 mL of an aqueous solution containing $3.3 \times 10^{-3}$ mol/L of magnesium chloride hexahydrate (25009-00™ manufactured by Kanto Kagaku, and having a special grade according to Japanese Industrial Standard) is added to 100 mL of a suspension containing $1.5 \times 10^{-3}$ mol/L of sodium n- hexylbenzenesulfonate, and the resultant mixture is stirred with a magnetic stirrer at 60°C for 3 hours. Then, 5 g of sodium chloride is added to the mixture to cause salting out.

A precipitate obtained by the salting out is dissolved in 100 mL of tetrahydrofuran at room temperature, and the resultant solution is filtered through a filter paper having a pore size of 5 $\mu$m under a reduced pressure. One mL of conc. ammonia (01266-00™ manufactured by Kanto Kagaku, and having a special grade according to Japanese Industrial Standard) is added to the filtrate, and the resultant mixture is stirred at 50°C for 3 hours. The mixture is evaporated with an evaporator. The resultant residue is dissolved in 100 mL of toluene (40500-01™ manufactured by Kanto Kagaku), and the resultant solution is filtered through a filter paper having a pore size of 3 $\mu$m under a reduced pressure. Magnesium sulfate (25035-00™ manufactured by Kanto Kagaku, and having a cica-special grade) is added to the resultant filtrate and the resultant is left around the clock. After the aqueous phase of the resultant is separated with a separatory funnel, the organic phase is evaporated with an evaporator to obtain flame-retardant fine particles D.

Preparation of flame-retardant fine particle E

100 mL of an aqueous solution containing $3.3 \times 10^{-3}$ mol/L of magnesium chloride hexahydrate (25009-00™ manufactured by Kanto Kagaku, and having a special grade according to Japanese Industrial Standard) is dripped into 100 mL of a suspension containing $3.0 \times 10^{-3}$ mol/L of sodium laurylphosphate, and the resultant mixture is stirred with a magnetic stirrer at 60°C for 3 hours. Then, 5 g of sodium chloride is added to the mixture to cause salting out.

A precipitate obtained by the salting out is dissolved in 100 mL of tetrahydrofuran at room temperature, and the resultant solution is filtered through a filter paper.having a pore size of 5 $\mu$m under a reduced pressure. One mL of conc. ammonia (01266-00™ manufactured by Kanto Kagaku, and having a special grade according to Japanese Industrial Standard) is added to the filtrate and the resultant mixture is stirred at 50°C for 3 hours. The mixture is evaporated with an evaporator. The resultant residue is dissolved in 100 mL of toluene (40500-01™ manufactured by Kanto Kagaku), and the resultant solution is filtered through a filter paper having a pore size of 3 $\mu$m under a reduced pressure. Magnesium sulfate (25035-00™ manufactured by Kanto Kagaku, and having a cica-special grade) is added to the resultant filtrate and the resultant is left around the clock. After the aqueous phase of the resultant is separated with a separatory funnel, the organic phase is evaporated with an evaporator to obtain flame-retardant fine particles E.

The particle size distribution of each of the flame-retardant fine particles A to E thus obtained is measured with a heterodyne volume average particle diameter distribution analyzer (MICROTRAC-UPA150 manufactured by Nikkiso Co., Ltd.). The measurement is performed at room temperature and toluene is used as a standard solvent.

In addition, the endothermic amounts of the flame-retardant fine particles B to E are obtained by differential scanning calorimetry (DSC). Specifically, the measurement is performed with differential scanning calorimeter (DSC-3200™ manufactured by Shimadzu Corporation) under a nitrogen atmosphere by increasing the temperature from room temperature to 450°C at a programming rate of 10°C/minute. The endothermic amounts are obtained from the areas of the respective endothermic peaks at around 400°C.

The results are summarized in Table 1.

Table 1

| Flame-retardant fine particle | A | B | C | D | E |
|---|---|---|---|---|---|
| Volume average particle diameter (nm) | 10.9 | 11.0 | 15.0 | 20.0 | 7.0 |
| Endothermic amount (J/g) | 5.6 | 11.9 | 2.4 | 47.6 | 40.3 |

As is apparent from Table 1, the flame-retardant fine particles B to E of the invention have a spherical shape and a small volume average particle diameter of 20 nm or less and a low degree of dispersion. In addition, the endothermic amounts of the flame-retardant fine particles A to E are almost the same and are in the range of about 2.4 to 47.6 J/g. From the results, it is expected that properties including flame-retardancy of these fine particles be similar. That is, since the flame-retardant fine particles B to E are expected to have properties similar to those of the flame-retardant fine particles A, the properties of the flame-retardant fine particles A are evaluated as described below.

<Example 1>

Preparation of flame-retardant resin composition and flame-retardant-resin formed article

Five parts by weight of the flame-retardant fine particles A are blended with 100 parts by weight of an ethylene/ vinyl acetate (EVA) copolymer (EV260™ manufactured by Du Pont-Mitsui Polychemicals Co., Ltd.) by using a biaxial extruder, and the resultant strands are hot-cut to obtain chips (flame-retardant resin composition). The chips thus obtained are pressed by a heat press (at 120°C for 10 minutes) to obtain a formed sheet (flame-retardant-resin formed article) 1 having a thickness of 2 mm.

The formed sheet 1 thus obtained is transparent and colorless, and the transmittance thereof measured with an ultraviolet-visible light spectrophotometer (UV-3150 manufactured by Shimadzu Corporation) is 65% at 550 nm.

In addition, a sample dispersion liquid obtained by dispersing 0.5 g of the flame-retardant fine particles in a solution in which 10 g of an EVA copolymer (EV260™ manufactured by Du Pont-Mitsui Polychemicals Co., Ltd.) has been dissolved in 100 mL of tetrahydrofuran is prepared for the cast film on a glass substrate and the resultant is dried at 60°C for 3 hours. Thereby, a film having a thickness of 20 $\mu$m is obtained. The transmittance of the film measured by the ultraviolet-visible light spectrophotometer is 65% at 550 nm.

Evaluation of flame-retardant resin composition and flame-retardant-resin formed article

The formed sheet 1 is evaluated by the following tests.

-Flame retardancy test-

A flame retardeance test based on ISO 5660-1, the disclosure of which is incorporated by reference herein, is conducted with a cone calorimeter (trade name: cone calorimeter IIIC3, manufacture by Toyo Seiki Seisaku-sho, Ltd.) and the relationship between the burning time and the heat release rate of the formed sheet 1 at an amount of radiant heat of 50 kW/m$^2$, and the smoke emission obtained by burning the formed sheet 1 are examined.

-Mechanical strength test-

Mechanical strength tests based on JIS K 7161, the disclosure of which is incorporated by reference herein, are conducted with an autograph (VI-C manufacture by Toyo Seiki Seisaku-sho, Ltd.). Tensile elastic modulus, tensile strength, and elongation at the time of breaking of the formed sheet 1 are obtained at normal temperature at a stress rate of 50 mm/min.

<Example 2 >

Five parts by weight of the flame-retardant fine particles A described above and 5 parts by weight of commercially available magnesium hydroxide (trade name: KISUMA 5A, manufactured by Kyowa Chemical Industry Co., Ltd.; volume average particle diameter: 1 $\mu$m) serving as a flame-retardant compound are blended with 100 parts by weight of an ethylene/vinyl acetate copolymer (trade name: EV260, manufactured by Du Pont-Mitsui Polychemicals Co., Ltd.) with a biaxial extruder, and the resulting strands are hot-cut to obtain chips. The chips are pressed by a heat press (at 120°C for 10 minutes) to obtain a formed sheet 2 having a thickness of 2 mm.

The formed sheet 2 obtained is opaque milk white. The formed sheet 2 is evaluated in the same manner as in Example 1.

<Comparative Example 1>

An ethylene/vinyl acetate copolymer (trade name: EV260, manufactured by Du Pont-Mitsui Polychemicals Co., Ltd.) is pressed by a heat press (at 120°C for 10 minutes) to obtain a formed sheet 3 having a thickness of 2 mm.
The formed sheet 3 thus obtained is transparent and colorless. The formed sheet 3 is evaluated in the same manner as in Example 1.

<Comparative Example 2>

Five parts by weight of commercially available magnesium hydroxide (trade name: KISUMA 5A, manufactured by Kyowa Chemical Industry Co., Ltd.; volume average particle diameter: 1 $\mu$m) serving as conventional flame-retardant fine particles is blended with 100 parts by weight of an ethylene/vinyl acetate copolymer (trade name: EV260, manufactured by Du Pont-Mitsui Polychemicals Co., Ltd.) with a biaxial extruder, and the resulting strands are hot-cut to obtain chips. The chips obtained are pressed by a heat press (at 120°C for 10 minutes) to obtain a formed sheet 4 having a thickness of 2 mm.
The formed sheet 4 obtained is opaque and milk white. The formed sheet 4 is evaluated in the same manner as in Example 1. In addition, a sample dispersion liquid obtained by dispersing 0.5 g of the conventional flame-retardant fine particles in a solution in which 10g of an ethylene-vinyl acetate copolymer (trade name: EV260, manufactured by Du Pont-Mitsui Polychemicals Co., Ltd.) has been dissolved in 100 mL of tetrahydrofuran is prepared for the cast film on a glass substrate, and the resultant is dried at 60°C for 3 hours. Thereby, a film having a thickness of 20 $\mu$m is obtained. The transmittance of the film, measured by the ultraviolet-visible light spectrophotometer, is 5% at 550 nm.

<Comparative Example 3>

25 parts by weight of commercially available magnesium hydroxide (trade name: KISUMA 5A, manufactured by Kyowa Chemical Industry Co., Ltd.; volume average particle diameter: 1 $\mu$m) serving as the conventional flame-retardant fine particles is blended with 100 parts by weight of an ethylene/vinyl acetate copolymer (trade name: EV260, manufactured by Du Pont-Mitsui Polychemicals Co., Ltd.) with a biaxial extruder, and the resulting strands are hot-cut to obtain chips. The chips are pressed by a heat press (at 120°C for 10 minutes) to obtain a formed sheet 5 having a thickness of 2 mm.
The formed sheet 5 obtained is opaque and milk white. The formed sheet 5 is evaluated in the same manner as in Example 1. In addition, a sample dispersion liquid obtained by dispersing 0.5 g of the conventional flame-retardant fine particles in a solution in which 10 g of ethylene-vinyl acetate copolymer (trade name: EV260, manufactured by Du Pont-Mitsui Polychemicals Co., Ltd.) has been dissolved in 100 mL of tetrahydrofuran is prepared for the cast film on a glass substrate, and the resultant is dried at 60°C for 3 hours. Thereby, a film having a thickness of 20 $\mu$m is obtained. The transmittance of the film measured by the ultraviolet-visible light spectrophotometer is 5% at 550 nm.
The formulations of the flame-resistant formed articles obtained in respective Examples and Comparative Examples are summarized in Table 2.

Table 2

| | Comparative Example 1 | Comparative Example 2 | Comparative Example 3 | Example 1 | Example 2 |
|---|---|---|---|---|---|
| Ethylene-vinyl acetate copolymer | 100 | 100 | 100 | 100 | 100 |
| Flame-retardant fine particle (average particle diameter: 22 nm) | - | - | - | 5 | 5 |

(continued)

| | Comparative Example 1 | Comparative Example 2 | Comparative Example 3 | Example 1 | Example 2 |
|---|---|---|---|---|---|
| Magnesium hydroxide (trade name: KISUMA 5A, manufactured by Kyowa Chemical Industry Co., Ltd.; average particle diameter: 1 $\mu$m) | | 5 | 25 | - | 5 |
| Total amount (parts) | 100 | 105 | 125 | 105 | 110 |

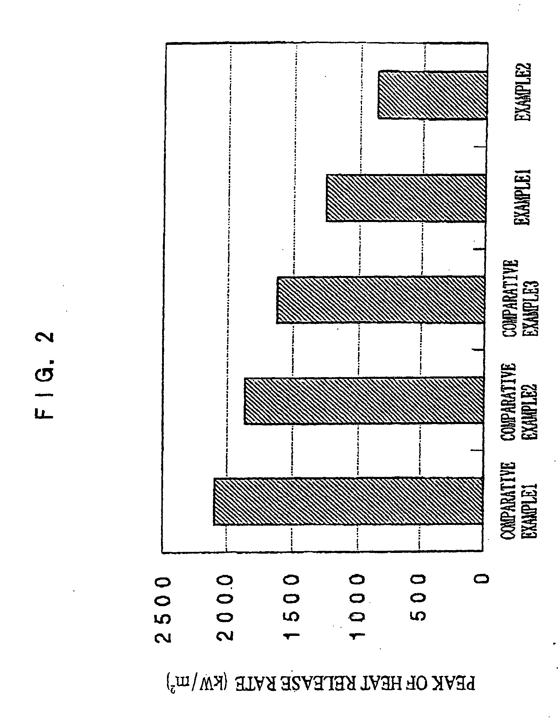

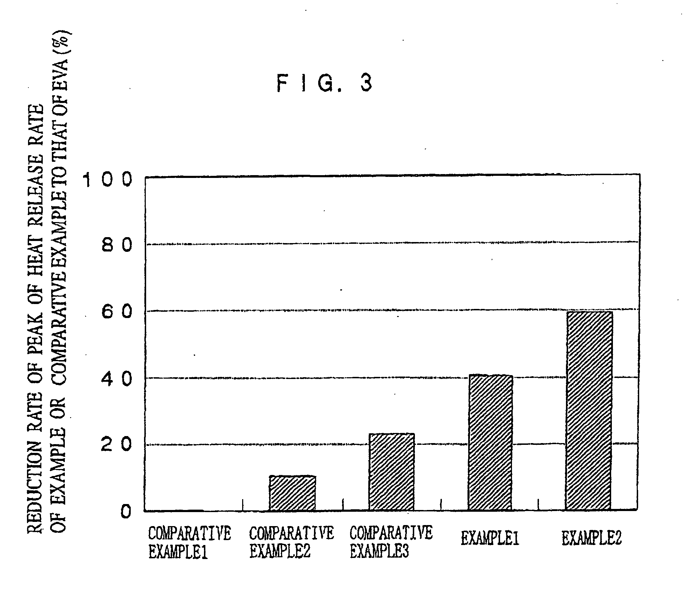

As the test results of the flame retardancy tests, the relationship between the heat release rate and the burning time of each formed sheet is shown in Fig. 1; graphical representation of the peak of heat release rate of the formed sheet in each of Comparative Examples and Examples is shown in Fig. 2; and graphical representation of the reduction rate of the peak of heat release rate of the formed sheet in each of Comparative Examples and Examples with respect to the peak of heat release rate of EVA alone in Comparative Example 1 is shown in Fig. 3.

As is apparent from Figs. 1 and 2, the heat release rate of EVA alone in Comparative Example 1 is high, and the peak of heat release rate is 2000 kW/m$^2$ or more. The peak of heat release rate of the formed sheet in Comparative Example 2 made of a blend of 5 parts by weight of the commercially available magnesium hydroxide (trade name: KISUMA 5A manufactured by Kyowa Chemical Industry Co., Ltd., volume average particle diameter: 1 $\mu$m) and 100 parts by weight of EVA is slightly lower than but is not significantly different from that of EVA in Comparative Example 1. However, the formed sheet in Example 1 made of a blend of 5 parts by weight of the flame-retardant fine particles in the invention and 100 parts by weight of EVA has the peak of heat release rate much lower than that of each of the sheets of Comparative Examples 1 and 2.

Further, the peak of heat release rate of the formed sheet in Example 1 is also much lower than that of the formed sheet in Comparative Example 3 made of a blend of 25 parts by weight of the commercially available magnesium hydroxide (trade name: KISUMA 5A manufactured by Kyowa Chemical Industry Co., Ltd., volume average particle diameter: 1 $\mu$m) and 100 parts by weight of EVA.

The above results indicate that the flame-retardant fine particles in the invention have a flame-retarding effect greater than that of the commercially available magnesium hydroxide (trade name: KISUMA 5A manufactured by Kyowa Chemical Industry Co., Ltd., volume average particle diameter: 1 $\mu$m). As shown in Fig. 3, the reduction rate of the peak of heat release rate (speed) of the flame-retardant resin composition in Example 1 to that of EVA alone in Comparative Example 1 is at least 40%.

The reduction rate of the peak of heat release rate of the flame-retardant resin composition in Example 1 to that of EVA alone is larger than that of the resin composition in Comparative Example 2 made of a blend of 5 parts by weight of the commercially available magnesium hydroxide (trade name: KISUMA 5A manufactured by Kyowa Chemical Industry Co., Ltd., volume average particle diameter: 1 $\mu$m) and 100 parts by weight of EVA to EVA alone by at least 30 %.

In addition, the reduction rate of the peak of heat release rate of the formed sheet in Example 2 made of a blend of 5 parts by weight of the flame-retardant fine particles in the invention and 5 parts by weight of the commercially available magnesium hydroxide (trade name: KISUMA 5A manufactured by Kyowa Chemical Industry Co., Ltd., volume average particle diameter: 1 $\mu$m) and 100 parts by weight of EVA to that of EVA alone in Comparative Example 1 is further greater than that of the formed sheet in Example 1 to EVA alone.

The results indicate that the flame-retardant fine particles in the invention exhibit a great flame-retarding effect even when used in combination with the commercially available flame-retardant compound having a larger particle diameter.

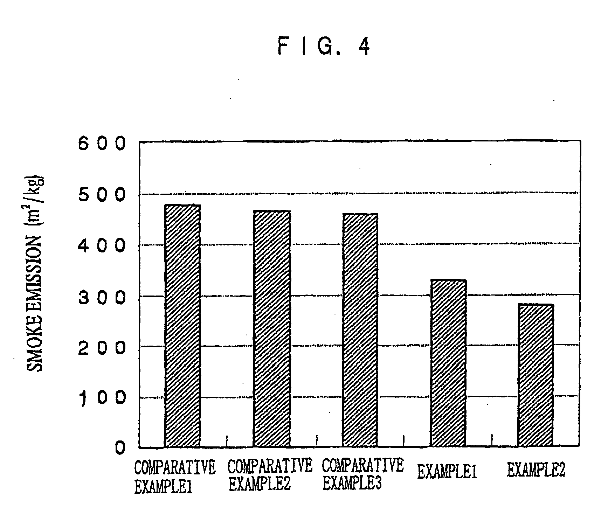

The smoke emission obtained by burning each of the formed articles prepared in respective Examples and Comparative Examples is shown in Fig. 4.

As shown in Fig. 4, the smoke emission obtained by burning EVA alone in Comparative Example 1 is high and 400 m$^2$/kg or more. The smoke emission obtained by burning the formed article of Comparative Example 2 containing 5 parts by weight of the commercially available magnesium hydroxide (trade name: KISUMA 5A, manufactured by Kyowa Chemical Industry Co., Ltd., volume average particle diameter: 1 $\mu$m) and 100 parts by weight of EVA is slightly lower than but is not significantly different from that obtained by burning EVA alone in Comparative Example 1. However, the smoke emission obtained by burning the formed article of Example 1 containing 5 parts by weight of the flame-retardant fine particles in the invention and 100 parts by weight of EVA is much lower than each of those obtained by burning the formed articles in Comparative Examples 1 and 2.

In addition, the smoke emission obtained by burning the formed sheet of Example 1 is much lower than that obtained by burning the formed sheet of Comparative Example 3 made of a blend of 25 parts by weight of the commercially available magnesium hydroxide (trade name: KISUMA 5A manufactured by Kyowa Chemical Industry Co., Ltd., volume average particle diameter: 1 $\mu$m) and 100 parts by weight of EVA.

Accordingly, the low smoke emission effect (smoke suppressing effect) of the flame-retardant fine particles in the invention is greater than that of the commercially available magnesium hydroxide (trade name: KISUMA 5A manufactured by Kyowa Chemical Industry Co., Ltd., volume average particle diameter: 1 $\mu$m).

Further, the smoke emission obtained by burning the formed article of Example 2 containing 5 parts by weight of the flame-retardant fine particles in the invention and 5 parts by weight of the commercially available magnesium hydroxide (trade name: KISUMA 5A manufactured by Kyowa Chemical Industry Co., Ltd., volume average particle diameter: 1 $\mu$m) and 100 parts by weight of EVA is lower than that generated by burning the formed sheet of Example 1.

These results indicate that the flame-retardant fine particles in the invention have a greater effect of suppressing smoke generation (greater low smoke emission effect), when they are used in combination with the commercially available flame-retardant compound having a greater particle size.

The elastic modulus, tensile strength, and elongation at the time of breaking of the formed articles of Examples and Comparative Examples which are obtained by the mechanical strength tests are summarized in the following Table 3.

Table 3

|  | Comparative Example 1 | Comparative Example 2 | Comparative Example 3 | Example 1 | Example 2 |
|---|---|---|---|---|---|
| Tensile elastic modulus (MPa) | 18.5 | 21.5 | 28.4 | 21.0 | 21.2 |
| Tensile strength (MPa) | 23.5 | 19.2 | 23.1 | 21.0 | 20.8 |
| Elongation at the time of break (%) | 1010 | 965 | 982 | 1021 | 1001 |

As is apparent form Table 3, the properties of the formed article of Comparative Example 2 containing 5 parts by weight of the commercially available magnesium hydroxide (trade name: KISUMA 5A manufactured by Kyowa Chemical Industry Co., Ltd., volume average particle diameter: 1 $\mu$m) and 100 parts by weight of EVA are not greatly different from those of the formed articles made of EVA alone of Comparative Example 1. On the other hand, the properties of the formed article of Example 1 containing 5 parts by weight of the flame-retardant fine particles A and 100 parts by weight of EVA are also not greatly different from those of the formed article of Comparative Example 1.

The results show that the formed article of Example 1 has mechanical properties similar to those of the formed article of Comparative Example 2 containing 5 parts by weight of the commercially available magnesium hydroxide (trade name: KISUMA 5A manufactured by Kyowa Chemical Industry Co., Ltd.; volume average particle diameter: 1 $\mu$m) and 100 parts by weight of EVA and to those of the formed article made of EVA in Comparative Example 1, and that use of the flame-retardant fine particles in the invention does not result in deterioration of the mechanical properties of a matrix resin.

The physical properties of the formed article of Example 2 containing 5 parts by weight of the flame-retardant fine particles A, 5 parts by weight of the commercially available magnesium hydroxide (trade name: KISUMA 5A manufactured by Kyowa Chemical Industry Co., Ltd.; volume average particle diameter: 1 $\mu$m) and 100 parts by weight EVA are not greatly different from those of the formed article of Comparative Example 2 and from those of the formed article made of EVA alone in Comparative Example 1.

The results show that, even when used in combination with a flame-retardant compound having a greater particle diameter, the flame-retardant fine particles in the invention do not cause the physical properties of a resin to deteriorate, and that therefore the resin composition including such a combination can have substantially the same physical properties substantially as those of the resin alone.

All of the above results indicate that the flame-retardant resin composition containing the flame-retardant fine particles of the invention has satisfactory flame retardancy, a satisfactory low smoke emission effect and physical properties which are similar to those of a matrix resin and provides the resultant formed article with appearance having transparency.

In addition, the flame-retardant fine particles in the invention provide the formed articles with satisfactory flame retardancy without the expense of the mechanical properties of a matrix resin, even when used together with a conventional flame retardant (flame-retardant compound).

From these results, the flame-retardant resin compositions containing the flame-retardant fine particles B to E are expected to have flame retardancy and mechanical properties similar to those of the composition containing the flame-retardant fine particles A.

**Claims**

1. A flame-retardant fine particle, comprising an inorganic fine particle made of a hydrated metal compound selected from aluminium hydroxide, magnesium hydroxide and calcium hydroxide and an organic compound on the surface ofthe inorganic fine particle and having a volume average particle diameter of between 1 to 500 nm and an aspect ratio of between 1 to 10, wherein the flame retardant fine particle is a material that is granular.

2. The flame-retardant fine particle of claim 1, further having a degree of dispersion of between 0.1 to 3.0.

3. The flame-retardant fine particle of claim 1 or claim 2, wherein the volume average particle diameter is in a range of between 1 to 200 nm.

4. The flame-retardant fine particle of any preceding claim, wherein the organic compound has a hydrophobic group capable of binding to the inorganic fine particle.

5. A flame-retardant resin composition, comprising a matrix resin, and the flame-retardant fine particles of any preceding claim blended therein.

6. The flame-retardant resin composition of claim 5, further comprising one or more flame-retardant compounds selected from hydrated metal compounds, nitrogen-containing compounds, and silicon-containing inorganic fillers, and having a particle diameter of between 0.5 to 50 $\mu$m.

7. The flame-retardant resin composition of claim 6, wherein the hydrated metal compound is selected from aluminium hydroxide, magnesium hydroxide, and calcium hydroxide the nitrogen-containing compound is sodium nitrate; and the silicon-containing inorganic filler is selected from molybdenum compounds, zirconium compounds, antimony compounds, dawsonite, phlogopite, and smectite.

8. The flame-retardant resin composition of claim 6 or claim 7, wherein the content of the one or more flame-retardant compounds is in a range ofbetween 0.1 to 200 parts by weight with respect to 100 parts by weight of the flame-retardant fine particles.

9. The flame-retardant resin composition ofany of claims 5 to 8, wherein the flame-retardant resin composition is highly nonflammable during combustion and has a low smoke emission function.

10. The flame-retardant resin composition of any of claims 5 to 9, wherein the peak ofheat release rate ofthe flame-retardant resin composition as specified according to ISO 5660-1 is at least 30% less than that ofthe matrix resin when it does not contain the flame-retaidant fine particles.

11. A flame-retardant resin formed article, formed from a flame-retardant resin composition by one or more forming machines selected from a press molding machine, an injection molding machine, a molding machine, a blow molding machine, an extrusion molding machine, and a fiber forming machine, wherein the flame-retardant resin composition in accordance with any of claims 6 to 10.

12. A process for producing flame-retardant resin compositions, comprising blending at least a matrix resin and flame-retardant fine particles by one or more kneading machines selected from a roll mill, a kneader, a Banbury mixer, an intermixer, a uniaxial extruder, and abiaxial extruder, wherein the flame-retardant fine particles are in accordance with any of claims 1 to 4.

13. A process for producing flame-retardant fine particles in accordance with any of claims 1 to 4, comprising:

preparing a suspension of an organic compound having a reactive group at a terminal of a hydrophobic group and/or in the hydrophobic group;

adding an inorganic compound having a group capable of binding to the reactive group to the suspension to conduct reaction between the inorganic compound and the organic compound; and

hydroxylating a product obtained by the reaction.

**Patentansprüche**

1. Schwer entflammbarer feiner Partikel, der einen anorganischen feinen Partikel aus einer hydratisierten Metallverbindung ausgewählt aus Aluminiumhydroxid, Magnesiumhydroxid und Calciumhydroxid und einer organischen Verbindung auf der Oberfläche des anorganischen feinen Partikels umfasst und einen volumengemittelten Partikeldurchmesser von 1 bis 500 nm und ein Seitenverhältnis von 1 bis 10 aufweist, wobei es sich bei dem schwer entflammbaren feinen Partikel um ein granulöses Material handelt.

2. Schwer entflammbarer feiner Partikel nach Anspruch 1 mit einem Dispersionsgrad von 0,1 bis 3,0.

3. Schwer entflammbarer feiner Partikel nach Anspruch 1 oder 2, bei dem der volumengemittelte Partikeldurchmesser im Bereich von 1 bis 200 nm liegt.

4. Schwer entflammbarer feiner Partikel nach einem der vorangegangenen Ansprüche, bei dem die organische Verbindung eine hydrophobe Gruppe besitzt, die sich an den anorganischen feinen Partikel binden kann.

5. Schwer entflammbare Harzzusammensetzung aus einem Matrixharz und damit vermischt den schwer entflammbaren feinen Partikeln nach einem der vorangegangenen Ansprüche.

6. Schwer entflammbare Harzzusammensetzung nach Anspruch 5, die weiterhin eine oder mehrere schwer entflammbare Verbindungen ausgewählt aus hydratisierten Metallverbindungen, stickstoffhaltigen Verbindungen und siliziumhaltigen anorganischen Füllstoffen umfasst und einen Partikeldurchmesser von 0,5 bis 50 $\mu$m aufweist.

7. Schwer entflammbare Harzzusammensetzung nach Anspruch 6, bei der die hydratisierte Metallverbindung aus Aluminiumhydroxid, Magnesiumhydroxid und Calciumhydroxid ausgewählt ist, die stickstoffhaltige Verbindung Natriumnitrat ist und der siliziumhaltige anorganische Füllstoff aus Molybdänverbindungen, Zirconiumverbindungen, Antimonverbindungen, Dawsonit, Phlogopit und Smectit ausgewählt ist.

8. Schwer entflammbare Harzzusammensetzung nach Anspruch 6 oder 7, bei der der Gehalt der einen oder mehreren schwer entflammbaren Verbindungen im Bereich von 0,1 bis 200 Gewichtsteilen bezogen auf 100 Gewichtsteile der schwer entflammbaren feinen Partikel liegt.

9. Schwer entflammbare Harzzusammensetzung nach einem der Ansprüche 5 bis 8, die bei Verbrennung hochgradig nichtentflammbar ist und eine niedrige Rauchemissionsfunktion aufweist.

10. Schwer entflammbare Harzzusammensetzung nach einem der Ansprüche 5 bis 9, bei der der Höchstwert der Wärmefreisetzungsgeschwindigkeit der schwer entflammbaren Harzzusammensetzung gemäß ISO 5660-1 um mindestens 30% niedriger liegt als der des Matrixharzes ohne die schwer entflammbaren feinen Partikel.

11. Formteil aus einem schwer entflammbaren Harz, das mit Hilfe einer oder mehrerer Formmaschinen ausgewählt aus einer Pressformmaschine, einer Spritzgussmaschine, einer Formmaschine, einer Blasformmaschine, einer Strangpressmaschine und einer Faserformmaschine aus einer schwer entflammbaren Harzzusammensetzung gebildet wird, wobei die schwer entflammbare Harzzusammensetzung den Ansprüchen 6 bis 10 entspricht.

12. Verfahren zur Herstellung schwer entflammbarer Harzzusammensetzungen, das Folgendes umfasst: Mischen mindestens eines Matrixharzes und schwer entflammbarer feiner Partikel mit Hilfe einer oder mehrerer Knetmaschinen ausgewählt aus einem Walzwerk, einer Knetvorrichtung, einem Banbury-Mischer, einem Intermixer, einem uniaxialen Extruder und einem biaxialen Extruder, wobei die schwer entflammbaren feinen Partikel den Ansprüchen 1 bis 4 entsprechen.

13. Verfahren zur Herstellung schwer entflammbarer feiner Partikel nach einem der Ansprüche 1 bis 4, das Folgendes umfasst:

Herstellen einer Suspension aus einer organischen Verbindung mit einer reaktiven Gruppe am Ende einer hydrophoben Gruppe und/oder in der hydrophen Gruppe;

Versetzen der Suspension mit einer anorganischen Verbindung mit einer Gruppe, die sich an die reaktive Gruppe binden kann, so dass eine Reaktion zwischen der anorganischen Verbindung und der organischen Verbindung stattfindet; und

Hydroxylieren eines in der Reaktion entstandenen Produktes.

## Revendications

1. Particule fine ignifuge, comprenant une particule fine inorganique faite d'un composé métallique hydraté choisi parmi l'hydroxyde d'aluminium, l'hydroxyde de magnésium et l'hydroxyde de calcium, et d'un composé organique sur la surface de la particule fine inorganique et ayant un diamètre moyen de particule en volume compris entre 1 et 500 nm et un allongement compris entre 1 et 10, dans laquelle la particule fine ignifuge est un matériau granulaire.

2. Particule fine ignifuge selon la revendication 1 ayant en outre un degré de dispersion de 0,1 à 3,0.

3. Particule fine ignifuge selon la revendication 1 ou la revendication 2, dans laquelle le diamètre moyen de particule en volume est compris entre 1 et 200 nm,

4. Particule fine ignifuge selon l'une quelconque des revendications précédentes, dans laquelle le composé organique a un groupe hydrophobe capable de se lier à la particule fine inorganique.

5. Composition de résine ignifuge, comprenant une résine matrice, et les particules fines ignifuges selon l'une quelconque des revendications précédentes mélangées à l'intérieur.

6. Composition de résine ignifuge selon la revendication 5, comprenant en outre un ou plusieurs composés ignifuges choisis parmi des composés métalliques hydratés, des composés contenant de l'azote, et des charges inorganiques contenant du silicium, et ayant un diamètre de particule compris entre 0,5 et 50 $\mu$m.

7. Composition de résine ignifuge selon la revendication 6, dans laquelle le composé métallique hydraté est choisi parmi l'hydroxyde d'aluminium, l'hydroxyde de magnésium, et l'hydroxyde de calcium, le composé contenant de l'azote est un nitrate de sodium ; et la charge inorganique contenant du silicium est choisie parmi des composés de molybdène, des composés de zirconium, des composés d'antimoine, de la dawsonite, de la phlogopite et de la smectite.

8. Composition de résine ignifuge selon la revendication 6 ou 7, dans laquelle la teneur en l'un ou plusieurs des composés ignifuges est comprise entre 0,1 et 200 parties en poids relativement à 100 parties en poids des particules fines ignifuges.

9. Composition de résine ignifuge selon l'une quelconque des revendications 5 à 8, dans laquelle la composition de résine ignifuge est hautement non-inflammable pendant la combustion et a une faible fonction d'émission de fumée.

10. Composition de résine ignifuge selon l'une quelconque des revendications 5 à 9, dans laquelle le pic du taux de libération de chaleur de la composition de résine ignifuge, tel que spécifié selon la norme ISO 5660-1, est au moins 30% inférieur à celui de la résine matrice quand elle ne contient pas les particules fines ignifuges.

11. Article réalisé en résine ignifuge, formé à partir d'une composition de résine ignifuge par une ou plusieurs machines de formation choisies parmi une machine de moulage sous pression, une machine de moulage par injection, une machine de moulage, une machine de soufflage, une machine de moulage par extrusion et une machine de formation de fibres, dans lequel la composition de résine ignifuge est conforme à l'une quelconque des revendications 6 à 10.

12. Procédé de production de compositions de résine ignifuge, comprenant le mélange d'au moins une résine matrice et de particules fines ignifuges par une ou plusieurs machines de malaxage choisies parmi un malaxeur à rouleaux, un malaxeur, un mélangeur Banbury, un inter-mélangeur, une extrudeuse uni-axiale, et une extrudeuse bi-axiale, dans lequel les particules fines ignifuges sont conformes à l'une quelconque des revendications 1 à 4.

13. Procédé de production de particules fines ignifuges selon l'une quelconque des revendications 1 à 4, comprenant :

la préparation d'une suspension d'un composé organique ayant un groupe réactif à une terminaison d'un groupe hydrophobe et/ou dans le groupe hydrophobe ;
l'addition d'un composé inorganique ayant un groupe capable de se lier au groupe réactif de la suspension pour réaliser la réaction entre le composé inorganique et le
composé organique ; et
l'hydroxylation d'un produit obtenu par la réaction.

F I G. 1

# F I G. 2

EP 1 528 083 B1

F I G. 3

REDUCTION RATE OF PEAK OF HEAT RELEASE RATE
OF EXAMPLE OR COMPARATIVE EXAMPLE TO THAT OF EVA (%)

F I G. 4

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003517488 A
- JP 2003509523 A